# EUROPEAN PATENT APPLICATION

(11) **EP 4 636 449 A1**
(43) Date of publication of application: **22.10.2025**
(21) Application number: 23914424.9
(22) Date of filing: 22.11.2023
(51) Int. Cl.: G02B 6/42, H04B 10/50, H01S 5/00

(54) **OPTICAL DEVICE, OPTICAL MODULE, AND ELECTRONIC DEVICE**

(30) Priority: 04.01.2023 CN 202310009753
(71) Applicant: Huawei Technologies Co., Ltd., Shenzhen, Guangdong 518129 (CN)
(72) Inventor: CHEN, Liuyong, Shenzhen, Guangdong 518129 (CN); LU, Weidong, Shenzhen, Guangdong 518129 (CN); CAO, Longgui, Shenzhen, Guangdong 518129 (CN); HE, Linfeng, Shenzhen, Guangdong 518129 (CN)
(74) Representative: Pfenning, Meinig & Partner mbB
(86) International application number: PCT/CN2023/133483
(87) International publication number: WO 2024/146289

(57) **Abstract**

Embodiments of this application provide an optical component, an optical module, and an electronic device, and relate to the field of optical communication technologies, to reduce costs of the optical component. The optical component includes at least one optical sub-assembly. The optical sub-assembly includes a laser, a first lens located on a light emergence side of the laser, and an optical fiber array located on a light emergence side of the first lens. The laser has a first light outlet configured to emit a first light beam and a second light outlet configured to emit a second light beam. The first lens is configured to: transmit the first light beam and emit a first converged light beam, is configured to: transmit the second light beam and emit a second converged light beam, and is configured to transmit the first converged light beam and the second converged light beam to the optical fiber array. A first optical fiber of the optical fiber array is configured to receive the first converged light beam, and a second optical fiber of the optical fiber array is configured to receive the second converged light beam.

## Description

This application claims priority to Chinese Patent Application No. 202310009753.8, filed with the China National Intellectual Property Administration on January 4, 2023 and entitled "OPTICAL COMPONENT, OPTICAL MODULE, AND ELECTRONIC DEVICE", which is incorporated herein by reference in its entirety.

### TECHNICAL FIELD

This application relates to the field of optical communication technologies, and in particular, to an optical component, an optical module, and an electronic device.

### BACKGROUND

With development of optical communication technologies, people have increasingly higher requirements for a bandwidth. A high-rate optical module is an inevitable trend for future development of optical communication technologies. Currently, a rate of an optical module has been rapidly increased from early 10 G to current 400 G or even 800 G.

A quantity of channels may be increased to increase the rate of the optical module. However, an increase in the quantity of channels leads to an increase in a size, costs, and power consumption of the optical module.

### SUMMARY

Embodiments of this application provide an optical component, an optical module, and an electronic device, to reduce costs and a size of the optical component.

To achieve the foregoing objective, the following technical solutions are used in this application.

A first aspect of embodiments of this application provides an optical component, including at least one optical sub-assembly. The optical sub-assembly includes a laser, a first lens located on a light emergence side of the laser, and an optical fiber array located on a light emergence side of the first lens. The laser has a first light outlet configured to emit a first light beam and a second light outlet configured to emit a second light beam. The first lens is configured to: transmit the first light beam and emit a first converged light beam, is configured to: transmit the second light beam and emit a second converged light beam, and is configured to transmit the first converged light beam and the second converged light beam to the optical fiber array. A first optical fiber of the optical fiber array is configured to receive the first converged light beam, and a second optical fiber of the optical fiber array is configured to receive the second converged light beam.

According to the optical component provided in embodiments of this application, a corresponding quantity of optical sub-assemblies may be set based on a multi-channel parallel solution. Compared with an existing optical component in which one laser has only one light outlet and one laser corresponds to one lens, an optical component in the multi-channel parallel solution needs to be implemented through cooperation of a plurality of lasers and a plurality of lenses. Consequently, a quantity of optical elements required by the optical component is increased with an increased quantity of channels, and costs and a size of the optical component are increased. In embodiments of this application, the two light outlets are integrated into the same laser, that is, the laser has dual light outlets (the first light outlet and the second light outlet). This reduces a quantity of lasers in the optical component. Then, the laser having dual light outlets is used together with the first lens. The first light beam is converged by the first lens, and the second light beam is converged by the first lens. In other words, the two light beams are converged by the same lens (the first lens) and then transmitted to the optical fiber array. This correspondingly reduces a quantity of lenses in the optical component. Finally, the first light beam is converged by the first lens and then transmitted to the first optical fiber of the optical fiber array, and the second light beam is converged by the first lens and then transmitted to the second optical fiber of the optical fiber array. In embodiments of this application, the laser having dual light outlets cooperates with the optical elements such as the first lens and the optical fiber array to implement optical transmission. Compared with conventional technologies, in embodiments of this application, the quantity of lasers and a quantity of first lenses that are required in the optical component can be reduced, the quantity of optical elements in the optical component is reduced, and a size of the optical component is reduced, thereby reducing a size of a packaging structure and simplifying a packaging process.

In a possible implementation, a distance L between the first light outlet or the second light outlet and the first lens and a focal length f of the first lens satisfy: f<L<2f. In this way, the first light beam and the second light beam that are emitted by the laser may form the first converged light beam and the second converged light beam after passing through the first lens.

In a possible implementation, the optical fiber array includes a first light inlet and a second light inlet, the first light inlet is coupled to the first optical fiber, the second light inlet is coupled to the second optical fiber, and a spacing between the first light inlet and the second light inlet is three to six times a spacing between the first light outlet and the second light outlet. In this way, the first converged light beam incident to the first light inlet and the second converged light beam incident to the second light inlet can be separated.

In a possible implementation, the spacing between the first light outlet and the second light outlet ranges from 20 µm to 40 µm.

In a possible implementation, a distance from the first light outlet to an optical axis of the first lens is the same as a distance from the second light outlet to the optical axis of the first lens. In this way, the first converged light beam and the second converged light beam that are converged by the first lens have equal sizes and opposite directions.

In a possible implementation, the optical sub-assembly further includes a second lens, the second lens is located on the light emergence side of the first lens, and the second lens is configured to converge the first converged light beam to the first optical fiber, and is further configured to converge the second converged light beam to the second optical fiber. In this way, the first converged light beam and the second converged light beam can be further converged to the optical fiber array.

In a possible implementation, the optical sub-assembly further includes an isolator, and the isolator is located on the light emergence side of the first lens. In this way, the first converged light beam and the second converged light beam can be transmitted unidirectionally, and the light beams are prevented from being reflected to the laser.

In a possible implementation, the optical component includes a plurality of optical sub-assemblies, the plurality of optical sub-assemblies are arranged along a second direction, and the second direction intersects with a light emitting direction of the laser. In this way, a multi-channel parallel optical component can be implemented.

In a possible implementation, the optical component further includes an optical fiber connector, and the optical fiber connector is connected to the optical fiber array through the first optical fiber and the second optical fiber. In this way, the optical component can be plugged in and out of an external device through the optical fiber connector, to implement an electrical connection.

A second aspect of embodiments of this application provides an optical module, including the optical component in the first aspect and a receiving optical sub-assembly, where the receiving optical sub-assembly receives an optical signal transmitted by the optical component.

The optical module provided in the second aspect of embodiments of this application includes the optical component in the first aspect. Beneficial effects of the optical module are the same as those of the optical component. Details are not described herein again.

A third aspect of embodiments of this application provides an electronic device, including the optical module in the second aspect, where the optical module is electrically connected to a printed circuit board.

The electronic device provided in the third aspect of embodiments of this application includes the optical module in the second aspect. Beneficial effects of the electronic device are the same as those of the optical module. Details are not described herein again.

### BRIEF DESCRIPTION OF DRAWINGS

FIG. 1 is a schematic structural diagram of a data center network system according to an embodiment of this application;
FIG. 2 is a schematic structural diagram of an optical component according to an embodiment of this application;
FIG. 3 is a schematic structural diagram of another optical component according to an embodiment of this application;
FIG. 4 is a schematic structural diagram of another optical component according to an embodiment of this application;
FIG. 5A is a schematic structural diagram of another optical component according to an embodiment of this application;
FIG. 5B is a schematic structural diagram of another optical component according to an embodiment of this application;
FIG. 5C is a schematic structural diagram of another optical component according to an embodiment of this application;
FIG. 6 is a schematic structural diagram of another optical component according to an embodiment of this application;
FIG. 7 is a schematic structural diagram of another optical component according to an embodiment of this application;
FIG. 8A is a schematic structural diagram of another optical component according to an embodiment of this application;
FIG. 8B is a schematic structural diagram of another optical component according to an embodiment of this application; and
FIG. 8C is a schematic structural diagram of another optical component according to an embodiment of this application.

### Reference numerals:

1-Data center network system; 2-Network; 3-Data center network; 31-Border leaf switch; 32-Spine switch; 33-Leaf switch; 4-Server; 10-Optical component; 11-Photonic integrated circuit; 12-Optical fiber array unit; 13-Optical fiber connector; 21-Laser; 22-Lens; 23-Optical fiber array unit; 24-Optical fiber connector; 100-Optical sub-assembly; 110-Laser; 111-First light outlet; 112-Second light outlet; 120-First lens; 220-Second lens; 130-Optical fiber array; 131-First optical fiber; 132-Second optical fiber; 140-Optical fiber connector; and 150-Isolator.

### DESCRIPTION OF EMBODIMENTS

The following describes the technical solutions in embodiments of this application with reference to the accompanying drawings in embodiments of this application. It is clear that the described embodiments are merely some rather than all of embodiments of this application.

The following terms such as "first" and "second" are merely used for ease of description, and shall not be understood as an indication or implication of relative importance or an implicit indication of a quantity of indicated technical features. Therefore, a feature limited by "second", "first", and the like may explicitly or implicitly include one or more features. In the descriptions of this application, unless otherwise stated, "a plurality of" means two or more than two.

In addition, in embodiments of this application, orientation terms such as "upper", "lower", "left", and "right" may include but are not limited to definitions based on illustrated orientations in which components in the accompanying drawings are placed. It should be understood that, these directional terms may be relative concepts, are used for relative description and clarification, and may change correspondingly based on changes in the orientations in which the components in the accompanying drawings are placed in the accompanying drawings.

In embodiments of this application, unless otherwise clearly specified and limited, the term "connection" should be understood in a broad sense. For example, the "connection" may be a fixed connection, a detachable connection, or an integrated connection, or may be a direct connection or an indirect connection implemented through an intermediate medium. In addition, the term "coupled" may be "directly electrically connected", or may be "indirectly electrically connected through an intermediate medium". The term "contact" may be direct contact, or may be indirect contact implemented through an intermediate medium.

In embodiments of this application, the term "and/or" describes an association relationship between associated objects and may indicate that three relationships exist. For example, A and/or B may indicate the following cases: Only A exists, both A and B exist, and only B exists, where A and B may be singular or plural. The character "/" generally indicates an "or" relationship between the associated objects.

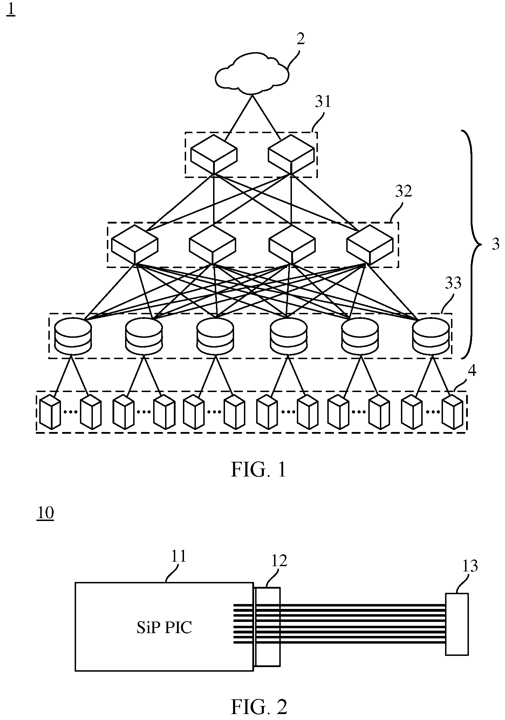

An embodiment of this application provides a data center network system. As shown in FIG. 1, the data center (data center) network system 1 mainly includes a network 2, a data center network 3, and a server (server) 4.

The data center network 3 is connected to the network 2 in an upstream direction, and is connected to the server 4 in a downstream direction.

For example, as shown in FIG. 1, the data center network 3 includes a border leaf switch 31, a spine switch 32, and a leaf switch 33. The border leaf switch 31 is connected to the network 2 in the upstream direction, and is connected to the spine switch 32 in the downstream direction. The spine switch 32 is connected to the border leaf switch 31 in the upstream direction, and is connected to the leaf switch 33 in the downstream direction. The leaf switch 33 is connected to the spine switch 32 in the upstream direction, and is connected to the server 4 in the downstream direction.

A plurality of border leaf switches 31 form a border leaf switch layer. A plurality of spine switches form a spine switch layer. A plurality of leaf switches 33 form a leaf switch layer.

The spine switch 32 is a switch that performs a converging function for leaf switch 33. Generally, the spine switch 32 is deployed at an upper layer of the leaf switch 33, and is configured to implement a packet routing or forwarding function between the leaf switches 33. To implement non-blocking forwarding, the spine switch 32 and the leaf switch 33 are generally connected through Clos networking. To be specific, for a multi-layer network architecture, each switching device at each layer is connected to all switching devices at a lower layer, so that a non-blocking (non-blocking), re-arrangeable (re-arrangeable), and scalable (scalable) architecture can be implemented. For example, the border leaf switch 31 and the spine switch 32 are also connected through Clos networking. The leaf switch 33 is generally disposed on the top of a rack of the server 4, serves as an access switch of the rack of the server 4, and is also referred to as a top of rack (top of rack, TOR) switch.

In some embodiments, the data center network system 1 further includes a data center network manager (data center network manager, DCNM) (not shown in the figure). The DCNM is configured to manage, through the network 2, the data center network 3 including a plurality of switches (the border leaf switch 31, the spine switch 32, and the leaf switch 33). For example, the DCNM may be implemented in a form of a server, and an application APP responsible for managing a network is integrated on the DCNM.

Embodiments of this application provide an optical module. The optical module may be disposed in the foregoing data center network system 1. Alternatively, the optical module may be disposed in any communication device that needs to receive a plurality of different wavelengths. This is not limited in embodiments of this application, and the optical module may be appropriately disposed based on an actual requirement.

Currently, three main solutions are available to increase a rate of the optical module. In a first solution, the rate of the optical module may be increased by increasing a rate of an optoelectronic chip inside the optical module. For example, performance of an optical modulator and an optoelectronic detector may be improved, and a rate of the optical modulator may be increased, thereby increasing a transmission rate of a single wavelength. In a second solution, the rate of the optical module may be increased by using a high-order modulation technology. In a third solution, the rate of the optical module may be increased by increasing a quantity of channels.

However, in the first solution, a breakthrough needs to be made on the optoelectronic chip to increase the rate of the optoelectronic chip. High costs are required to increase the rate of the optoelectronic chip, and a technology is not mature. Consequently, it needs to take very long time to implement the solution.

In the second solution, as the rate of the optical module increases from 100 G to 400 G, a modulation form of an intensity modulation/direct detection (IM/DD) optical module is also improved from an on-off keying (on-off keying, OOK) modulation to pulse amplitude modulation (pulse amplitude modulation, PAM). The high-order modulation leads to a small noise margin for the optical module. Therefore, complex processing circuits are subsequently required.

In the third solution, the rate of the optical module can be quickly increased by increasing the quantity of channels, and the solution has become a most commonly used manner of increasing the rate of the optical module currently. The quantity of channels may be increased by using a plurality of parallel channels or a plurality of serial channels. For example, the plurality of parallel channels may be parallel single mode (parallel single mode, PSM) fibers. The plurality of serial channels may be combined by using an optical multiplexer (optical multiplexer, OMUX), to output an optical signal.

In some embodiments, the optical module is electrically connected to a printed circuit board (printed circuit board, PCB) and is integrated into an electronic device. The electronic device may include, for example, a server, a switch, an optical fiber network adapter, and an optical fiber transceiver.

For example, the optical module includes a transmitting optical sub-assembly (transmitting optical sub-assembly, TOSA) and a receiving optical sub-assembly (receiving optical sub-assembly, ROSA). Both the transmitting optical sub-assembly and the receiving optical sub-assembly are electrically connected to the printed circuit board.

For example, the transmitting optical sub-assembly includes an electrical-to-optical conversion chip and a monitor photodiode (MD). The electrical-to-optical conversion chip and the monitor photodiode are packaged together to form the transmitting optical sub-assembly. The electrical-to-optical conversion chip may be, for example, a chip including a laser diode (laser diode, LD) or a chip including a semiconductor light emitting diode. The electrical-to-optical conversion chip receives an electrical signal that carries sending information and that is transmitted by the PCB, converts the electrical signal into an optical signal, and outputs the optical signal through an optical component 10.

For example, the receiving optical sub-assembly includes an optical-to-electrical conversion chip and an amplifier. The optical-to-electrical conversion chip and the amplifier are packaged together to form the receiving optical sub-assembly. For example, the optical-to-electrical conversion chip may be a chip including a photodiode (photodiode, PD), a chip including a PIN diode (pin diode), or a chip including an avalanche photodiode (avalanche photodiode, APD). The optical-to-electrical conversion chip converts a received optical signal into an electrical signal, and then transmits the electrical signal to the amplifier. The amplifier amplifies the electrical signal, and transmits an amplified electrical signal to the PCB.

The following uses an example in which the optical component provided in embodiments of this application is the transmitting optical sub-assembly for description.

To increase the rate of the optical module by increasing the quantity of channels, an integrated chip solution or a discrete component solution may be generally used.

An 800 G optical component is used as an example to illustrate a multi-channel parallel optical component based on an integrated chip solution. As shown in FIG. 2, the optical component 10 includes a photonic integrated circuit (photonic integrated circuit, PIC) 11, a fiber array unit (fiber array unit, FAU) 12, and an optical fiber connector 13.

The photonic integrated circuit is integrated and packaged based on silicon photonics (silicon photonics, SiP). During SiP integration, the optical component has high integration, and the FAU is directly connected to a SiP chip. Even if the quantity of channels continues to be increased based on an actual requirement, manufacturing costs of the optical component are not increased linearly with the quantity of channels. Therefore, multi-channel parallel implemented based on an integrated chip has a great advantage.

However, due to a limitation of a characteristic of a silicon-based material, the optical component 10 based on the integration solution cannot be monolithically integrated with a laser chip, and requires an external light source or an on-chip hybrid integrated light source. Therefore, process complexity of the optical component 10 based on the integration solution is increased. For an 800 G DR8 multi-channel parallel solution, at least four extra lasers need to be integrated to transmit an optical signal.

In the foregoing solution, a plurality of lasers are required, and a required SiP chip structure is complex. Therefore, a size and costs of the optical component 10 are increased.

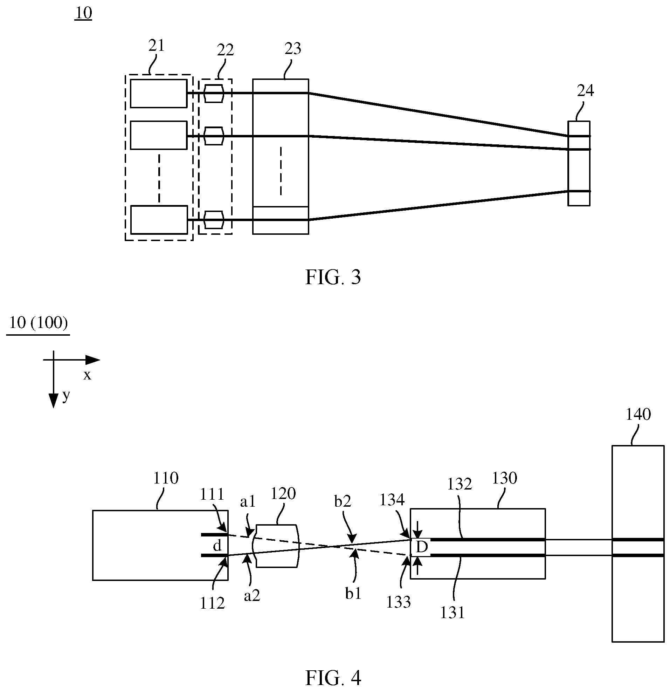

Embodiments of this application further show an optical component. The optical component is a multi-channel parallel solution based on a discrete component. As shown in FIG. 3, the optical component 10 includes a plurality of lasers 21, a plurality of lenses 22, an optical fiber array unit 23, and an optical fiber connector 24. One laser 21 corresponds to one lens 22. In an 8-channel discrete component solution, eight lasers 21 and eight lenses 22 need to be disposed, and emitting light beams of the lasers 21 are separately converged to the optical fiber array unit 23 through the lenses 22, and then transmitted to the optical fiber connector 24.

In the multi-channel parallel solution based on a discrete component, an increase in a quantity of channels leads to an increase in a quantity of lasers and a quantity of lenses in the optical component 10, and an increase in complexity of the optical component 10 and a quantity of optical elements. Consequently, a size, costs, and power consumption of an optical module are increased. Especially, when the optical module is upgraded from a 400 G 4-channel (400 G DR4) optical module to an 800 G 8-channel (800 G DR8) optical module, the increase in the quantity of channels leads to an increase in a package size of the optical component. Consequently, it is difficult to miniaturize the optical component.

In view of this, to reduce the size and the costs of the optical component, embodiments of this application further provide an optical component. As shown in FIG. 4, the optical component 10 includes at least one optical sub-assembly 100. The optical sub-assembly 100 includes a laser 110, a first lens 120, and an optical fiber array 130.

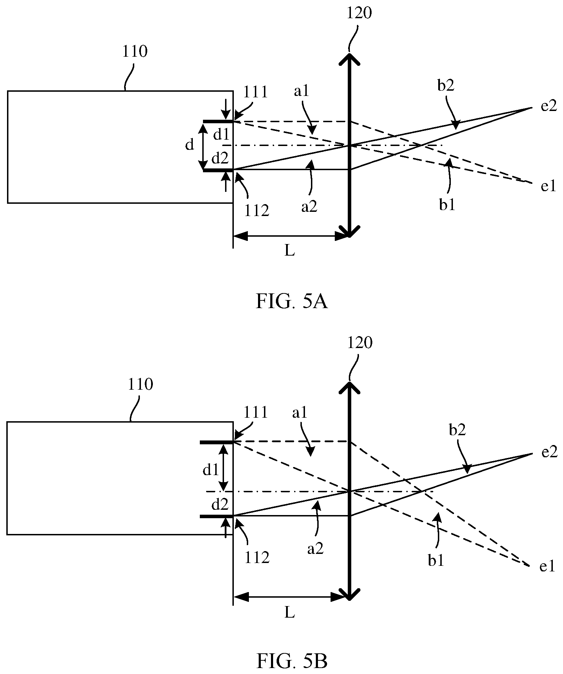

As shown in FIG. 5A, the laser 110 is a laser having dual light outlets. The laser 110 has a first light outlet 111 and a second light outlet 112. In other words, the first light outlet 111 and the second light outlet 112 are disposed on a light emergence side of the laser 110.

The first light outlet 111 emits a first light beam a1, and the second light outlet 112 emits a second light beam a2. A wavelength of the first light beam a1 may be the same as or different from a wavelength of the second light beam a2. This is not limited in embodiments of this application, and the wavelengths may be appropriately set based on an actual requirement.

For example, the wavelength of the first light beam a1 emitted from the first light outlet 111 is the same as the wavelength of the second light beam a2 emitted from the second light outlet 112.

Still refer to FIG. 4. There is a spacing d between the first light outlet 111 and the second light outlet 112. In other words, along a second direction y, there is a distance d between the first light outlet 111 and the second light outlet 112 of the laser 110. The second direction y intersects with a light emitting direction x of the laser 110.

For example, the spacing d between the first light outlet 111 and the second light outlet 112 ranges from 20 µm to 40 µm. For example, the spacing d may be 20 µm, 23 µm, 25 µm, 28 µm, 30 µm, 33 µm, 37 µm, or 40 µm. This is not limited in embodiments of this application, and the spacing may be appropriately set based on an actual requirement.

For example, a distance from a central position of the first light outlet 111 to a central position of the second light outlet 112 is considered as the spacing d between the first light outlet 111 and the second light outlet 112.

Alternatively, a distance from the topmost of the first light outlet 111 to the topmost of the second light outlet 112 may be considered as the spacing d between the first light outlet 111 and the second light outlet 112.

Alternatively, a distance from the bottommost of the first light outlet 111 to the bottommost of the second light outlet 112 may be considered as the spacing d between the first light outlet 111 and the second light outlet 112.

Still refer to FIG. 4. The first lens 120 is located on the light emergence side of the laser 110. After being transmitted through the first lens 120, the first light beam a1 and the second light beam a2 are transmitted to the optical fiber array 130.

In other words, the first lens 120 is located on an emitting optical path of the laser 110.

For example, as shown in FIG. 4, the laser 110 and the first lens 120 are arranged along a first direction x. The first direction x intersects with the second direction y. For example, the first direction x is perpendicular to the second direction y.

As shown in FIG. 4, the optical fiber array 130 is located on a light emergence side of the first lens 120. The optical fiber array 130 receives a converged light beam. After the first light beam a1 and the second light beam a2 pass through the first lens 120, converged light beams are formed.

In other words, along a light transmission direction, the first light beam a1 or the second light beam a2 has a smaller cross section of the light beam until the cross section becomes a point, where the point is referred to as a convergence point of the light beam.

For example, the first lens 120 is configured to: separately converge the first light beam a1 and the second light beam a2, and emit a first converged light beam b1 and a second converged light beam b2.

To be specific, the first lens 120 is configured to: converge the first light beam a1, and emit the first converged light beam b1, and the first lens 120 is further configured to: converge the second light beam a2, and emit the second converged light beam b2.

For example, the first lens 120 may include any one of a Fresnel lens, a holographic lens, or a plano-convex lens.

Based on an optical characteristic, a focal length f of the first lens 120 and a distance L between the first lens 120 and the light outlets of the laser 110, to be specific, the first light outlet 111 and the second light outlet 112 of the laser 110 satisfy: f<L<2f. After the first light beam a1 and the second light beam a2 pass through the first lens 120, the first converged light beam b1 and the second converged light beam b2 can be formed. In other words, convergence of the first light beam a1 and the second light beam a2 can be implemented, and a convergence point e1 and a convergence point e2 are formed.

It is explained herein that positions of the convergence point e1 and the convergence point e2 are determined by L and f. When the focal length f of the first lens 120 is determined, changing the laser 110 is specifically changing positions of the first light outlet 111, the second light outlet 112, and the first lens 120, so that the positions of the convergence point e1 and the convergence point e2 can be changed.

The first lens 120 has an optical axis, to be specific, a straight line that passes through a center of the first lens 120 and that is perpendicular to the first lens 120. The optical axis in embodiments of this application is described as follows: After incident light is emitted by a lens, emergent light still propagates along a straight line where the incident light is located and does not refract. Both the incident light and the emergent light are on one straight line, and the straight line where the incident light and the emergent light are located is an optical axis of the lens.

For a position relationship between the laser 110 and the first lens 120, in some embodiments, as shown in FIG. 5A, the first light outlet 111 and the second light outlet 112 of the laser 110 are respectively located on different sides of the optical axis of the first lens 120.

In other words, the optical axis of the first lens 120 is located between the first light outlet 111 and the second light outlet 112. The optical axis of the first lens 120 may be located in a middle position between the first light outlet 111 and the second light outlet 112. Alternatively, the optical axis of the first lens 120 may be closer to the first light outlet 111. Alternatively, the optical axis of the first lens 120 may be closer to the second light outlet 112.

For example, as shown in FIG. 5A, a distance d1 from the first light outlet 111 to the optical axis of the first lens 120 is the same as a distance d2 from the second light outlet 112 to the optical axis of the first lens 120, and the first light outlet 111 and the second light outlet 112 are symmetrical about the optical axis of the first lens 120. In other words, the optical axis of the first lens 120 may be located in the middle position between the first light outlet 111 and the second light outlet 112.

In this case, the spacing d between the first light outlet 111 and the second light outlet 112 is a sum of the distance d1 from the first light outlet 111 to the optical axis of the first lens 120 and the distance d2 from the second light outlet 112 to the optical axis of the first lens 120, that is, d=d1+d2.

In other words, the first light beam a1 emitted from the first light outlet 111 and the second light beam a2 emitted from the second light outlet 112 are symmetrical about the optical axis of the first lens 120.

In this way, after the first light beam a1 and the second light beam a2 separately pass through the first lens 120, the emitted first converged light beam b1 and the emitted second converged light beam b2 are also symmetrical about the optical axis of the first lens 120.

Herein, an included angle between the first converged light beam b1 and the optical axis is denoted as α1, and an included angle between the second converged light beam b2 and the optical axis is denoted as α2.

As shown in FIG. 5A, a value of the included angle α1 or the included angle α2 is determined by the spacing d between the first light outlet 111 and the second light outlet 112 and the distance L between the light outlets and the first lens 120.

To be specific, the value of the included angle α1 is determined by the distance d1 from the first light outlet 111 to the optical axis of the first lens 120 and the distance L from the first light outlet 111 to the first lens 120, that is, tan α1=d1/L.

The value of the included angle α2 is determined by the distance d2 from the second light outlet 112 to the optical axis of the first lens 120 and the distance L from the second light outlet 112 to the first lens 120, that is, tan α2=d2/L.

Because the distance d1 from the first light outlet 111 to the optical axis of the first lens 120 is equal to the distance d2 from the second light outlet 112 to the optical axis of the first lens 120, that is, d1=d2, tan α1=tan α2. Therefore, the value of the included angle α1 is the same as the value of the included angle α2.

A direction of the included angle α1 is opposite to a direction of the included angle α2. The direction herein means that using the optical axis as a start end, if the included angle with the optical axis is above the optical axis, the direction of the included angle is denoted as a positive direction, or if the included angle with the optical axis is below the optical axis, the direction of the included angle is denoted as a negative direction. If the included angle α1 is above the optical axis, the direction of the included angle α1 is a positive direction. If the included angle α2 is below the optical axis, the direction of the included angle α2 is a negative direction.

Alternatively, for example, as shown in FIG. 5B, the distance d1 from the first light outlet 111 to the optical axis of the first lens 120 is different from the distance d2 from the second light outlet 112 to the optical axis of the first lens 120.

FIG. 5B is shown by using an example in which d1>d2, to be specific, the optical axis of the first lens 120 is located at a position closer to the second light outlet 112.

In this case, the spacing d between the first light outlet 111 and the second light outlet 112 is the sum of the distance d1 from the first light outlet 111 to the optical axis of the first lens 120 and the distance d2 from the second light outlet 112 to the optical axis of the first lens 120, that is, d=d1+d2.

The value of the included angle α1 is related to the distance d1 from the first light outlet 111 to the optical axis of the first lens 120 and the distance L from the first light outlet 111 to the first lens 120, and the value of the included angle α2 is related to the distance d2 from the second light outlet 112 to the optical axis of the first lens 120 and the distance L from the second light outlet 112 to the first lens 120, that is, tan α1=d1/L, and tan α2=d2/L. Because d1>d2, tan α1>tan α2. That is, α1>α2. Therefore, the value of the included angle α1 is greater than the value of the included angle α2.

In addition, because the included angle α1 and the included angle α2 are respectively above and below the optical axis of the first lens 120, the direction of the included angle α1 is opposite to the direction of the included angle α2.

To be specific, the value of the included angle α1 is different from the value of the included angle α2, and the direction of the included angle α1 is opposite to the direction of the included angle α2.

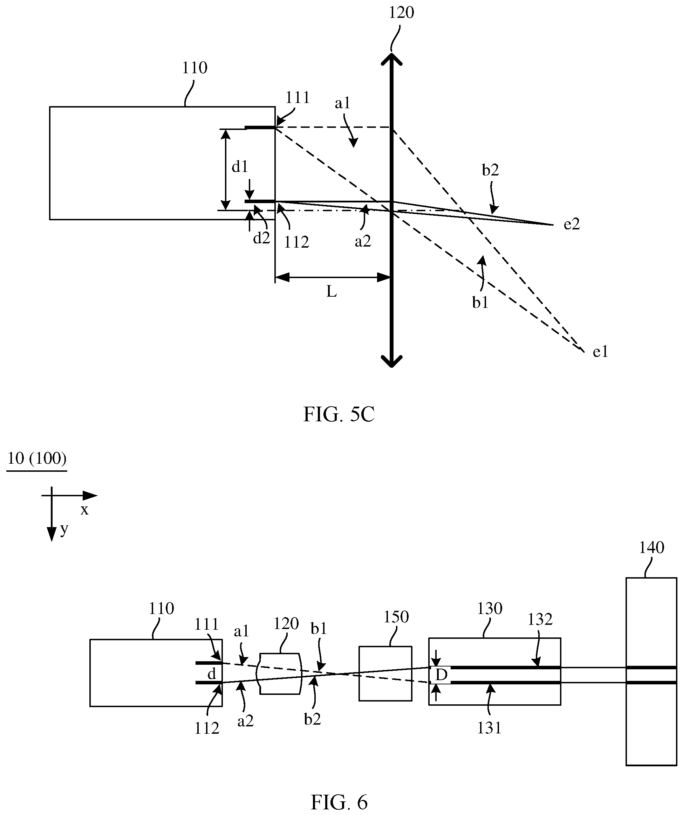

In some other embodiments, as shown in FIG. 5C, the first light outlet 111 and the second light outlet 112 are located on the same side of the optical axis of the first lens 120, and the distance d1 from the first light outlet 111 to the optical axis of the first lens 120 is different from the distance d2 from the second light outlet 112 to the optical axis of the first lens 120. An example in which the distance d1 from the first light outlet 111 to the optical axis of the first lens 120 is greater than the distance d2 from the second light outlet 112 to the optical axis of the first lens 120, that is, d1>d2 is used for description.

In other words, both the first light outlet 111 and the second light outlet 112 are above the optical axis of the first lens 120 or below the optical axis of the first lens 120.

In this case, the spacing d between the first light outlet 111 and the second light outlet 112 is a difference between the distance d1 from the first light outlet 111 to the optical axis of the first lens 120 and the distance d2 from the second light outlet 112 to the optical axis of the first lens 120, that is, d=|d1-d2|.

In this case, the value of the included angle α1 is different from the value of the included angle α2, and the direction of the included angle α1 is the same as the direction of the included angle α1.

In embodiments of this application, the distance d1 from the first light outlet 111 to the optical axis of the first lens 120 and the distance d2 from the second light outlet 112 to the optical axis of the first lens 120 are not limited, and may be appropriately set based on an actual requirement.

For ease of description, the following uses an example in which the distance d1 from the first light outlet 111 to the optical axis of the first lens 120 is the same as the distance d2 from the second light outlet 112 to the optical axis of the first lens 120 for description. That is, d1=d2 is used as an example for description. In other words, the first light outlet 111 and the second light outlet 112 are symmetrical about the optical axis of the first lens 120.

Still refer to FIG. 4. The optical fiber array 130 includes a first optical fiber 131 and a second optical fiber 132, and the first optical fiber 131 and the second optical fiber 132 are spaced apart.

The optical fiber array 130 further includes a first light inlet 133 and a second light inlet 134. The first optical fiber 131 is coupled to the first light inlet 133, and the second optical fiber 132 is coupled to the second light inlet 134. There is a distance D between the first light inlet 133 and the second light inlet 134.

For example, the distance D between the first light inlet 133 and the second light inlet 134 is three to six times the distance d between the first light outlet 111 and the second light outlet 112, that is, 3d<D<5d.

For example, the distance D between the first light inlet 133 and the second light inlet 134 ranges from 125 µm to 200 µm. For example, the distance D may be 125 µm, 127 µm, 136 µm, 149 µm, 153 µm, 166 µm, 174 µm, 183 µm, or 197 µm.

In this way, the first converged light beam b1 incident to the first light inlet 133 and the second converged light beam b2 incident to the second light inlet 134 can be separated, to prevent the first converged light beam b1 from entering the second light inlet 134 or prevent the second converged light beam b2 from entering the first light inlet 133.

It is explained herein that if the first optical fiber 131 and the second optical fiber 132 are disposed in parallel with the optical axis of the first lens 120, the spacing D between the first light inlet 133 and the second light inlet 134 is a spacing between the first optical fiber 131 and the second optical fiber 132.

The first optical fiber 131 receives the first converged light beam b1, and the second optical fiber 132 receives the second converged light beam b2. In other words, the convergence point e1 of the first converged light beam b1 is located on a light incidence side of the first optical fiber 131, and the convergence point e2 of the second converged light beam b2 is located on a light incidence side of the second optical fiber 132.

Still refer to FIG. 4. In some embodiments, the optical sub-assembly 100 further includes an optical fiber connector 140. The optical fiber connector 140 is connected to the optical fiber array 130 through the first optical fiber 131 and the second optical fiber 132.

For example, the optical fiber connector 140 is an MT ferrule optical fiber connector. Alternatively, the optical fiber connector 140 may be an LC optical fiber connector or an FC (ferrule connector) optical fiber connector.

When the optical component 10 needs to be optically connected to an external device, the optical component 10 may be plugged in and out of the external device through the optical fiber connector 140, to implement an electrical connection.

In some embodiments, as shown in FIG. 6, the optical sub-assembly 100 further includes an isolator 150.

The isolator 150 is located on the light emergence side of the first lens 120. The isolator 150 is further located on a light incidence side of the optical fiber array 130.

In other words, the isolator 150 is located on a transmission optical path of the first converged light beam b1 and the second converged light beam b2.

A function of the isolator 150 is to enable the first converged light beam b1 and the second converged light beam b2 to be transmitted unidirectionally, to avoid a case in which the first converged light beam b1 and the second converged light beam b2 are reflected to the laser 110, causing damage to the laser 110.

The isolator 150 may implement unidirectional transmission of the first converged light beam b1 and the second converged light beam b2 at the same time. Therefore, one isolator 150 is correspondingly disposed for one first lens 120. In the optical component 10 provided in embodiments of this application, a quantity of required isolators 150 is reduced.

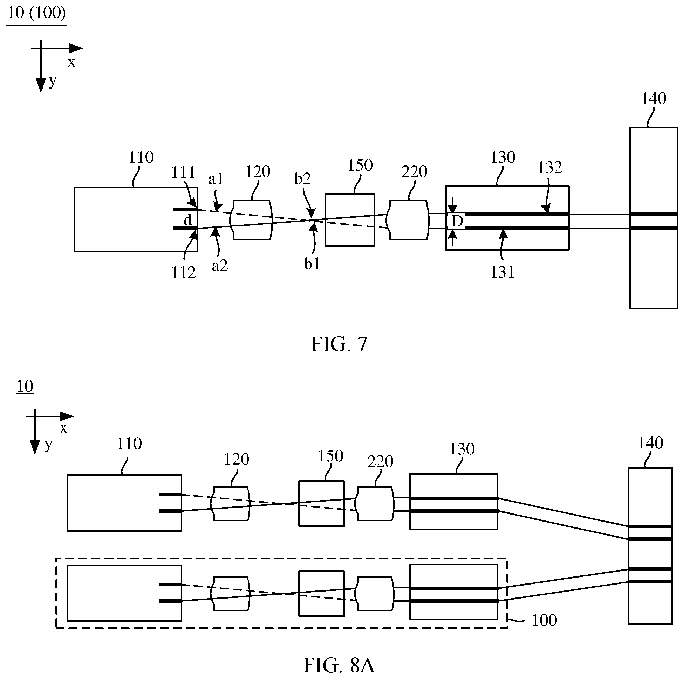

In some embodiments, as shown in FIG. 7, the optical sub-assembly 100 further includes a second lens 220.

The second lens 220 is located on the light emergence side of the first lens 120. The second lens 220 is further located on the light incidence side of the optical fiber array 130.

For example, the second lens 220 is located on a light emergence side of the isolator 150.

In other words, the second lens 220 is located on the transmission optical path of the first converged light beam b1 and the second converged light beam b2.

The second lens 220 is configured to further converge the first converged light beam b1 and the second converged light beam b2, so that the first converged light beam b1 can be better converged to the first optical fiber 131, and the second converged light beam b2 can be better converged to the second optical fiber 132.

The second lens 220 may further converge the first converged light beam b1 and the second converged light beam b2. Therefore, one second lens 220 is correspondingly disposed for one first lens 120. In the optical component 10 provided in embodiments of this application, a quantity of required second lenses 220 is reduced.

Therefore, in the optical component 10 provided in embodiments of this application, one first lens 120, one isolator 150, and one second lens 220 are correspondingly disposed for one laser 110, so that a quantity of required optical elements in the optical component 10 can be reduced by at least half.

It is explained herein that the optical component 10 includes one optical sub-assembly 100. The optical component 10 is applicable to an optical component 10 with two parallel channels for output (DR2).

In some embodiments, the optical component 10 includes a plurality of optical sub-assemblies 100. The plurality of optical sub-assemblies 100 are arranged in the second direction y. In embodiments of this application, the plurality of optical sub-assemblies 100 may be disposed to satisfy a quantity of parallel channels for output in the optical component 10.

For example, as shown in FIG. 8A, the optical component 10 includes two optical sub-assemblies 100.

In this way, the optical component 10 is applicable to an optical component 10 with four parallel channels for output (DR4).

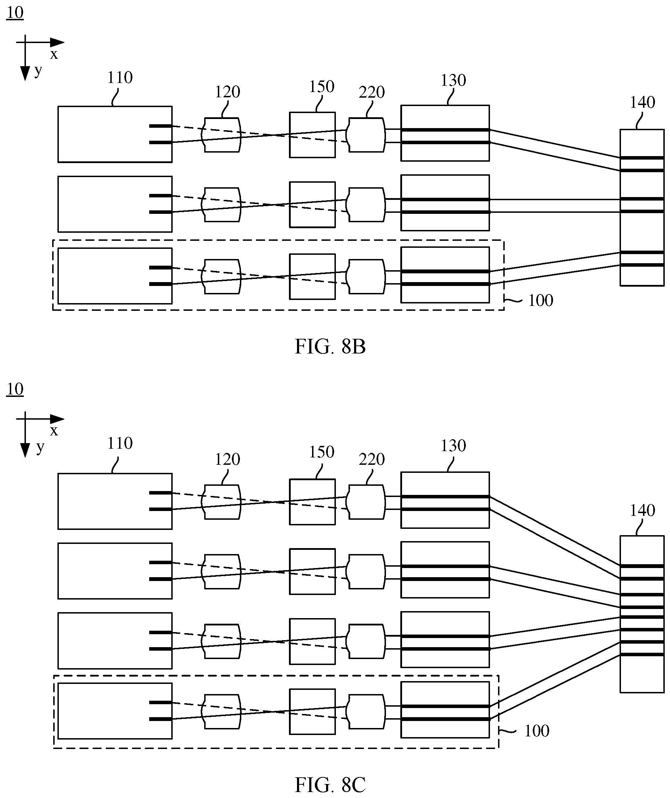

Alternatively, for example, as shown in FIG. 8B, the optical component 10 includes three optical sub-assemblies 100.

In this way, the optical component 10 is applicable to an optical component 10 with six parallel channels for output (DR6).

Alternatively, for example, as shown in FIG. 8C, the optical component 10 includes four optical sub-assemblies 100.

In this way, the optical component 10 is applicable to an optical component 10 with eight parallel channels for output (DR8).

The optical component 10 includes a plurality of optical sub-assemblies 100. To be specific, the optical component 10 includes a plurality of lasers 110, a plurality of first lenses 120, and a plurality of optical fiber arrays 130. The plurality of optical fiber arrays 130 may be integrated into one packaging housing. A plurality of optical fiber connectors 140 may be corresponding multi-channel optical fiber connectors.

A quantity of optical sub-assemblies 100 in the optical component 10 is not limited in embodiments of this application, and may be appropriately set based on an actual requirement.

It is explained herein that when the optical component 10 includes the plurality of optical sub-assemblies 100, the plurality of optical fiber arrays 130 may be integrated together, or may be disposed separately. This is not limited in embodiments of this application, provided that in the same optical sub-assembly 100, the spacing D between the first optical fiber 131 and the second optical fiber 132 and the spacing d between the first light outlet 111 and the second light outlet 112 satisfy: 3d<D<5d.

The optical component 10 provided in embodiments of this application includes at least one optical sub-assembly 100. The optical sub-assembly 100 includes the laser 110, the first lens 120 located on the light emergence side of the laser 110, and the optical fiber array 130 located on the light emergence side of the first lens 120. The laser 110 has the first light outlet 111 configured to emit the first light beam a1 and the second light outlet 112 configured to emit the second light beam a2. The first lens 120 is configured to: transmit the first light beam a1 and emit the first converged light beam b1, is configured to: transmit the second light beam a2 and emit the second converged light beam b2, and is configured to transmit the first converged light beam b1 and the second converged light beam b2 to the optical fiber array 130. The first optical fiber 131 of the optical fiber array 130 is configured to receive the first converged light beam b1, and the second optical fiber 132 of the optical fiber array 130 is configured to receive the second converged light beam b2. According to the optical component 10 provided in embodiments of this application, a corresponding quantity of optical sub-assemblies 100 may be set based on a multi-channel parallel solution. Compared with an existing optical component in which one laser 110 has only one light outlet and one laser 110 corresponds to one lens 120, an optical component 10 in the multi-channel parallel solution needs to be implemented through cooperation of a plurality of lasers 110 and a plurality of lenses 120. Consequently, a quantity of optical elements required by the optical component 10 is increased with an increased quantity of channels, and costs and a size of the optical component 10 are increased. In embodiments of this application, the two light outlets are integrated into the same laser 110, that is, the laser 110 has dual light outlets (the first light outlet 111 and the second light outlet 112). This reduces a quantity of lasers 110 in the optical component 10. Then, the laser 110 having dual light outlets is used together with the first lens 120. The first light beam a1 is converged by the first lens 120, and the second light beam a2 is converged by the first lens 120. In other words, the two light beams are converged by the same lens (the first lens 120) and then transmitted to the optical fiber array 130. This correspondingly reduces a quantity of first lenses 120 in the optical component 10. Finally, the first light beam a1 is converged by the first lens 120 and then transmitted to the first optical fiber 131 of the optical fiber array 130, and the second light beam a2 is converged by the first lens 120 and then transmitted to the second optical fiber 132 of the optical fiber array 130. In embodiments of this application, the laser 110 having dual light outlets cooperates with the optical elements such as the first lens 120 and the optical fiber array 130 to implement optical transmission. Compared with conventional technologies, in embodiments of this application, the quantity of lasers 110 and the quantity of first lenses 120 that are required in the optical component 10 can be reduced, the quantity of optical elements in the optical component 10 is reduced, and a size of the optical component 10 is reduced, thereby reducing a size of a packaging structure and simplifying a packaging process.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. An optical component, comprising at least one optical sub-assembly, wherein the optical sub-assembly comprises:
a laser, having a first light outlet and a second light outlet, wherein the first light outlet is configured to emit a first light beam, and the second light outlet is configured to emit a second light beam;
a first lens, located on a light emergence side of the laser, wherein the first lens is configured to: transmit the first light beam and emit a first converged light beam, and is further configured to: transmit the second light beam and emit a second converged light beam; and
an optical fiber array, located on a light emergence side of the first lens, wherein the optical fiber array comprises a first optical fiber and a second optical fiber, the first optical fiber is configured to receive the first converged light beam, and the second optical fiber is configured to receive the second converged light beam.

2. The optical component according to claim 1, wherein a distance L between the first light outlet or the second light outlet and the first lens and a focal length f of the first lens satisfy: f<L<2f.

3. The optical component according to claim 1 or 2, wherein the optical fiber array comprises a first light inlet and a second light inlet, the first light inlet is coupled to the first optical fiber, the second light inlet is coupled to the second optical fiber, and a spacing between the first light inlet and the second light inlet is three to six times a spacing between the first light outlet and the second light outlet.

4. The optical component according to any one of claims 1 to 3, wherein the spacing between the first light outlet and the second light outlet ranges from 20 µm to 40 µm.

5. The optical component according to any one of claims 1 to 4, wherein a distance from the first light outlet to an optical axis of the first lens is the same as a distance from the second light outlet to the optical axis of the first lens.

6. The optical component according to any one of claims 1 to 5, wherein the optical sub-assembly further comprises a second lens, the second lens is located on the light emergence side of the first lens, and the second lens is configured to converge the first converged light beam to the first optical fiber, and is further configured to converge the second converged light beam to the second optical fiber.

7. The optical component according to any one of claims 1 to 6, wherein the optical sub-assembly further comprises an isolator, and the isolator is located on the light emergence side of the first lens.

8. The optical component according to any one of claims 1 to 7, wherein the optical component comprises a plurality of optical sub-assemblies, the plurality of optical sub-assemblies are arranged along a second direction, and the second direction intersects with a light emitting direction of the laser.

9. The optical component according to any one of claims 1 to 8, wherein the optical component further comprises an optical fiber connector, and the optical fiber connector is connected to the optical fiber array through the first optical fiber and the second optical fiber.

10. An optical module, comprising the optical component according to any one of claims 1 to 9 and a receiving optical sub-assembly, wherein the receiving optical sub-assembly receives an optical signal transmitted by the optical component.

11. An electronic device, comprising the optical module according to claim 10 and a printed circuit board, wherein the optical module is electrically connected to the printed circuit board.
